# EUROPÄISCHE PATENTSCHRIFT

(11) **EP 1 818 987 B1**
(45) Veröffentlichungstag und Bekanntmachung des Hinweises auf die Patenterteilung: **07.12.2011**
(21) Anmeldenummer: 07102058.0
(22) Anmeldetag: 09.02.2007
(51) Int. Cl.: H01L 25/065, H01L 21/98, H01L 21/60, H01L 21/00

(54) **Halbleiterbauelementanordnung**
Semi-conductor component assembly
Agencement de composant semi-conducteur

(30) Priorität: 10.02.2006 EP 06101553
(43) Veröffentlichungstag der Anmeldung: 15.08.2007
(73) Patentinhaber: ELMOS Semiconductor AG, 44227 Dortmund (DE)
(72) Erfinder: Rost, Wolfgang, 44137, Dortmund (DE)
(74) Vertreter: von Kreisler Selting Werner

(56) Entgegenhaltungen:
- EP-A- 0 379 120
- EP-A- 0 696 055
- EP-A- 1 630 867
- US-A- 6 098 278
- US-A1- 2005 136 568
- US-A1- 2006 017 069
- US-B1- 6 348 405
- PATENT ABSTRACTS OF JAPAN Bd. 1997, Nr. 01, 31. Januar 1997 (1997-01-31) -& JP 08 250495 A (SONY CORP), 27. September 1996 (1996-09-27)

## Beschreibung

Die Erfindung betrifft eine Halbleiterbauelementanordnung und insbesondere die elektrische und mechanische Verbindung zweier Halbleiterbauelemente durch einen elektrisch leitenden Kleber.

Anordnungen von übereinander positionierten Halbleiterbauelementen (sogenanntes "Chip-on-Chip-Assembly" oder auch "stacked die" genannt) sind im Stand der Technik grundsätzlich bekannt. Ein Beispiel für eine derartige Anordnung ist in EP-A-0 696 055 beschrieben.

Ein weiteres Beispiel ist in US-A-6,098,278 gezeigt (siehe Fign. 6A und 6B). Hier sind in einer elektrisch isolierenden Außenschicht eines Chips Kontaktfenster ausgebildet, innerhalb derer Anschlussfelder einer mit den Bond-Pads des Chips verbundenen Metallisierungsebene freiliegen. Die Kontaktfenster sind mit Leitkleber ausgefüllt, mit dem Anschlussfelder eines PCB in elektrisch leitendem Kontakt stehen. Der elektrische Kontakt des Leitklebers zur Metallisierungsebene (Anschlussfelder und Leiterbahnen) des Chips erfolgt ausschließlich innerhalb der freiliegenden Anschlussfelder.

Bei den bekannten Halbleiterbauelementanordnungen werden die Kontakt- oder Anschlussfelder benachbarter Halbleiterbauelemente mittels elektrisch leitender Kleber (Leitkleber) verbunden, wodurch neben der elektrischen Verbindung auch eine mechanische Verbindung gegeben ist. Für eine gute elektrische Verbindung wird dabei gefordert, dass die Kontaktbereiche frei von Schichten sind, die den elektrischen Kontakt/Strornfluss behindern.

So sind z.B. Aluminium oder Aluminiumlegierungen wegen der schnellen Reaktion mit Luftsauerstoff unter Bildung einer dünnen isolierenden Oxidschicht auf der Oberfläche nicht für die Kontaktierungsklebung geeignet. Anders als beim Drahtbonden wird nämlich die Oxidschicht durch den Leitkleber nicht aufgebrochen. Geeignete Materialien, aus denen die zu kontaktierende Oberfläche bestehen könnte, wären zum Beispiel weitgehend resistente Edelmetalle wie Gold, Platin, Palladium u.a. Abgesehen von zusätzlichen Prozess- und Anlagenkosten sind diese Metalle bekanntermaßen selbst nicht billig.

Bei der Herstellung beispielsweise eines Halbleiterchips wird zur Strukturierung der (oberen) Metallschicht eine Antireflexionsbeschichtung (ARC, antireflective coating) in Form beispielsweise einer Titannitridschicht aufgebracht. Diese Schicht schützt ferner die Metallschicht und die in dieser strukturierten Metallisierungsleitbahnen vor einer Oxidation. Herkömmlicherweise wird im Zuge der Herstellung des Halbleiterchips nach der Strukturierung der Metallschicht eine ein- oder mehrlagige Passivierungsschicht aufgebracht, in die mittels Ätztechnik Fensteröffnungen eingebracht werden, innerhalb derer Kontaktbereiche der Metallisierungsleitbahnen frei liegen. Für das Drahtbonden wird gefordert, dass sich innerhalb der Fensteröffnungen kein Antireflexionsmaterial mehr befindet. Mit anderen Worten wird also die beispielsweise aus Titannitrid bestehende ARC-Schicht beim Freilegen der Fensteröffnungen mit weg geätzt. Soll aber nun beispielsweise ein Kontaktfenster bzw. einige wenige Kontaktfenster über beispielsweise einen Leitkleber direkt mit einem Anschlusskontaktfeld eines weiteren Halbleiterbauelements verbunden werden, so wäre es wünschenswert, innerhalb dieses Kontaktfensters die Antireflexionsschicht stehen zu lassen. Abgesehen davon, dass dies im Zuge des Freiätzens sämtlicher Bondpadöffnungen nicht möglich ist, existieren darüber hinaus auch keine Ätzverfahren, die derart selektiv sind, dass innerhalb nur bestimmter Fensteröffnungen lediglich die Passivierungsschicht weggeätzt wird, um die darunter befindliche Antireflexionsschicht stehen zu lassen. Dies ist umso schwieriger, als diese Antireflexionsschichten sehr dünn sind (< 100 nm).

Um nach klassischer Herangehensweise eine solide Prozessierung vorzunehmen, ist es erforderlich, in einem ersten Fototechnik/Ätzschritt in der Passivierungsschicht das Fenster für die Klebekontaktierung zu öffnen, wobei die sich auf der obersten Aluminium-Leitbahn befindliche Titannitridschicht (ARC-Schicht) in diesem Bereich entfernt wird, was im Folgenden eine erneute Titannitrid-Abscheidung und Strukturierung (Fototechnik/Ätzschritt) erforderlich macht. Weil die verfügbaren Plasmaätzverfahren, wie zuvor beschrieben, nicht gleichzeitig ausreichend selektiv gegenüber der Passivierungsschicht und dem Metall, z.B. Aluminium der Bondpads sind, ist zum Öffnen der Fenster für das Drahtbonden ein weiterer Fototechnik/Ätzschritt vorzunehmen. Diese technologische Variante ist zwar produktionstauglich, aber sehr aufwendig.

Aufgabe der Erfindung ist es, ohne zusätzliche Prozessschritte wie z.B. Fototechnik/Masken, Ätzschritte, Schichtabscheidungen mindestens ein Kontaktfenster eines ersten Halbleiterbauelements zur Klebekontaktierung mit einem Anschlusskontaktfeld eines zweiten Halbleiterbauelements auszubilden, wobei die Klebekontaktierung eine ausreichend gute elektrische Verbindung bildet.

Zur Lösung dieser Aufgabe wird mit der Erfindung eine Halbleiterbauelementanordnung vorgeschlagen, die versehen ist mit den Merkmalen des Anspruchs 1. Die Unteransprüche betreffen einzelne Weiterbildungen der Erfindung.

Sinngemäß wird mit der Erfindung vorgeschlagen, die gewöhnlich zur Überflächenoxidation (d.h. Selbstpassivierung) neigende Metallschicht mit einer elektrisch leitenden Schutzschicht zu bedecken, welche keiner bzw. keiner sich nachteilig auf die elektrische Kontaktierbarkeit auswirkende Oberflächen-Selbstpassivierung unterliegt, und die in einem Kontaktfenster frei liegenden Ätzkanten der Schutzschicht, welche sich unterhalb der Ätzkanten der Passivierungsschicht befinden, für die elektrisch leitende Verbindung zu nutzen. Über die Schutzschicht entsteht ausgehend von der Metallschicht zunächst eine elektrische Verbindung in Dickenerstreckung der Schutzschicht und innerhalb der Schutzschicht in ihrer Erstreckungsebene bis zu den Ätzkanten. Der dort die Schutzschicht kontaktierende Leitkleber sorgt für die elektrische Anbindung der Schutzschicht. Der Stromfluss braucht also in erster Linie nicht über die wegen der Neigung zur Selbstpassivierung unzuverlässige Kontaktierung des Leitklebers mit der Metallschicht innerhalb eines für die Klebekontaktierung vorgesehenen Kontaktfensters zu erfolgen, sondern über die elektrische Verbindung, die zwischen dem Leitkleber, den Ätzkanten der Schutzschicht und durch diese hindurch zur Metallschicht besteht.

Erfindungsgemäß weist das Kontaktfenster des ersten Halbleiterbauelements zur Verlängerung seines Randes eine Vielzahl von Einzelkontaktfensterbereichen auf. Zweckmäßig ist es, wenn durch Strukturierung der Passivierungs- und der Schutzschicht deren Ätzkante sich über eine möglichst große Länge über einem Kontaktbereich der Metallschicht (Pad) erstreckt. Dies kann beispielsweise realisiert werden, indem der Kontaktfensterrand in das Kontaktfenster hineinragende Nasen oder dergleichen Strukturen aufweist bzw. wenn sich innerhalb des Kontaktfensters einzelne Inseln bestehend aus der Passivierungsschicht mit darunter angeordneter Schutzschicht befinden. Sinn und Zweck ist es hierbei, die Kantenlänge des Kontaktfensters zu verlängern, so dass über eine möglichst lange Ätzkantenerstreckung elektrisch leitender Kleber in Kontakt mit der Schutzschicht und über diese mit dem darunter angeordneten Metallkontaktfeld elektrisch leitend verbunden ist.

Die Erfindung lässt sich auf denkbar einfache Weise in bestehende Halbleitertechnologie-Prozesse integrieren, ohne dass diese nennenswert geändert werden müssen. Die Veränderung gegenüber herkömmlicher Halbleitertechnologie-Prozessen besteht darin, dass innerhalb eines für die Klebekontaktierung vorgesehenen Kontaktfensters Bereiche der Passivierungsschicht mit darunter angeordneter Schutzschicht verbleiben. Mit anderen Worten betrifft die minimale erfindungsgemäß erforderliche Veränderung eine Abänderung der Fotomaske, mit der die Bildung der Kontaktfenster vorbereitet wird. Die anschließenden Prozesse, insbesondere der Ätzprozess, sind genau so, wie für die für das Drahtbonden vorgesehenen Kontaktfenster.

Je nach dem verwendeten Halbeitertechnologie-Prozess existiert die Schutzschicht auf der Metallschicht (noch) nicht. In diesen Prozessen sollte erfindungsgemäß eine solche Schutzschicht als Schutz von einer Oberflächenoxidation der Metallschicht vorgesehen werden. Es existieren aber auch Prozesse, bei denen eine solche Schutzschicht bereits vorhanden ist. Ein Beispiel für eine erfindungsgemäß nutzbare Schutzschicht ist die Antireflexionssicht aus z.B. TiN, die zur Reduktion möglicher Reflexionen bei einer durch einen fotolithographischen Prozess erzeugten Strukturierung der Metallschicht häufig verwendet wird. Bei diesen Prozessen entfällt also das Erfordernis, zur Realisierung der Erfindung die Schutzschicht als weitere Schicht im Prozess auf die Metallschicht auftragen zu müssen, da die Antireflexionsschicht die Schutzfunktion mit übernimmt.

Vorteilhaft im Hinblick auf eine Vergrößerung der Anbindungsfläche zwischen dem Leitkleber und der Ätzkante der Schutzschicht ist es, wenn zumindest in Teilbereichen der Ätz- bzw. Seitenkanten von Passivierungsschicht und Schutzschicht eine Kontaktierungsschicht aus einem elektrisch leitenden Material angeordnet ist. Diese vertikale Schicht kann grundsätzlich unter Verwendung der in der Halbleitertechnologie bekannten Verfahren zur Erzeugung vertikaler Schichten realisiert werden. Besonders zweckmäßig ist es, wenn man diese Kontaktierungsschicht durch anisotropes Ätzen eines zuvor aufgebrachten Kontaktierungsmaterials erzeugt. Derartig erzeugte Vertikal-Schichten werden in anderen Halbleitertechnologieprozessen (beispielsweise bei MOS-Transistoren) auch als Spacer bezeichnet. Als Material für die Kontaktierungsschicht eignet sich insbesondere TiN.

Die Erfindung wird nachfolgend anhand der Zeichnung näher erläutert. Im einzelnen zeigen dabei
- Fig. 1: einen Schnitt durch einen Halbleiterchip mit einem LED-Chip mit Rückseitenkontaktierung, die über einen elektrisch leitenden Kleber innerhalb eines Kontaktfensters des Halbleiterchips mit dessen Metallschicht bzw. einer in dieser ausgebildeten Metallleiterbahn elektrisch verbunden ist,
- Fig. 2: eine Draufsicht auf die Oberseite des Halbleiterchips im Bereich der für die Klebekontaktierung vorbereiteten Kontaktfensters des Halbleiterchips, wobei in Fig. 2 mit I-I die Schnittebene gemäß Fig. 1 angegeben ist,
- Fig. 3: eine Variante der Ausbildung des für die Klebekontaktierung vorgesehenen Kontaktfensters,
- Fig. 4: ein weiteres Ausführungsbeispiel der Strukturierung des Passivierungs- und Antireflexionsschicht innerhalb eines für die Klebekontaktierung vorgesehenen Kontaktfensters des Halbleiterchips,
- Fig. 5: eine weitere Variante eines für die Klebekontaktierung vorgesehenen Kontaktfensters mit in dieses hineinragenden Strukturen aus Passivierungs- und darunter befindlicher Antireflexionsschicht,
- Fig. 6: ein zusätzliches Ausführungsbeispiel der Ausgestaltung eines für die Klebekontaktierung vorgesehenen Kontaktfensters des Halbleiterchips mit in dieses vom Rand aus hineinragenden Vorsprüngen aus Passivierungsschicht und Antireflexionsschicht und
- Fig. 7: einen Schnitt durch einen Halbleiterchip mit einem LED-Chip mit Rückseitenkontaktierung, die gemäß einem letzten Ausführungsbeispiel über einen elektrisch leitenden Kleber innerhalb eines Kontaktfensters des Halbleiterchips mit dessen Metallschicht bzw, einer in dieser ausgebildeten Metallleiterbahn elektrisch verbunden ist.

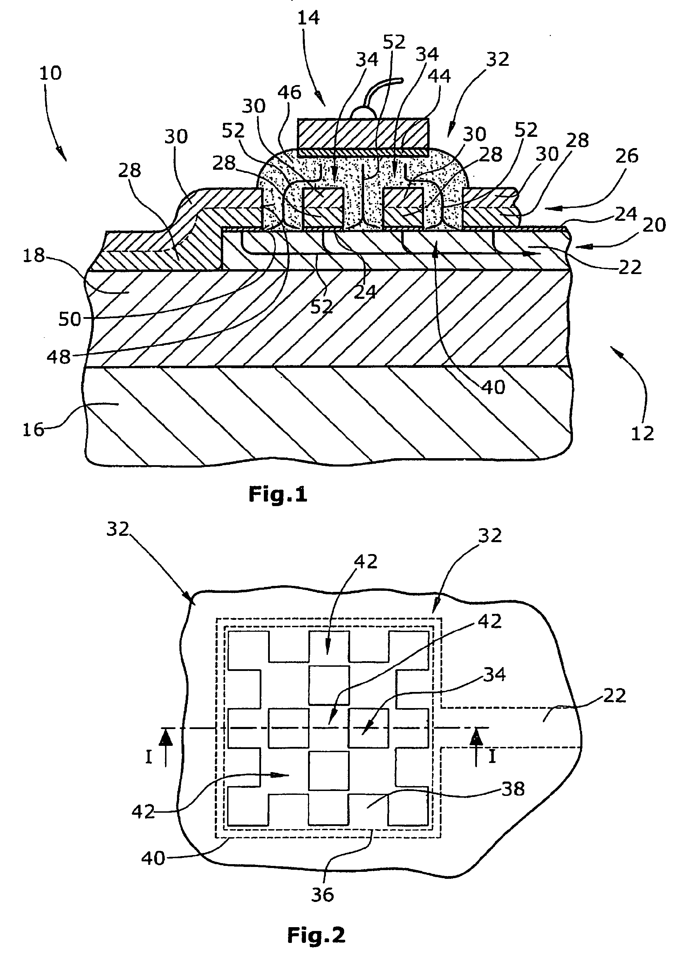

In Fig. 1 ist eine Halbleiterbauelementanordnung 10 gemäß einem ersten Ausführungsbeispiel der Erfindung gezeigt, die in diesem Fall aus einem Halbleiterchip 12 als ein erstes Halbleiterbauelement und einem Lichtemitterdioden (LED-)Chip 14 als ein zweites Halbleiterbauelement besteht. Der Halbleiterchip 12 weist ein Siliziumsubstrat 16 (Bulk-Material) auf, auf dem sich eine Isolationsschicht aus SiO₂ 18 befindet. Innerhalb des Siliziumsubstrats 16 sind aktive Gebiete mit elektronischen Halbleiterbauelementen ausgebildet, was in Fig. 1 nicht gezeigt ist. Durch die Isolationsschicht 18 sind diese oberflächennahen Bereiche des Siliziumsubstrats 16 gegenüber einer Metallschicht 20 elektrisch isoliert, die einzelne Metallisierungsbahnen 22 aufweist, von denen eine in Fig. 1 gezeigt ist. Auf der beispielsweise 1 µm dicken Metallschicht 20 befindet sich eine dünne Antireflexionsschicht 24 von < 100 nm (beispielsweise etwa 50 nm), die aus TiN besteht. Nach der Strukturierung der Metallschicht 20 wird auf die Antireflexionsschicht 24 eine Passivierungsschicht 26 aufgebracht, die auf der Oberfläche des Wafers und damit in diesem Ausführungsbeispiel zweilagig ausgebildet ist und aus einer etwa 500 nm dicken Schicht 28 aus Phosphorsilikatglas (PSG) und einer ebenfalls etwa 500 nm dicken Schicht 30 aus Siliziumnitrid besteht.

In die Passivierungsschicht 26 sind diverse Kontaktfenster für das Drahtbonden eingebracht, die in Fig. 1, nicht gezeigt sind. Diese Kontaktfenster werden durch Ätzen erzeugt, wobei neben der Passivierungsschicht 26 auch das Material der Antireflexionsschicht 24 weggeätzt wird. Mit anderen Worten liegen also die Anschlussfelder der im Regelfall aus Aluminium oder einer Aluminiumlegierung bestehenden Metallisierungsbahnen 22 in den Kontaktfenstern frei.

In diesem Ausführungsbeispiel der Erfindung ist zumindest eines der Kontaktfenster als Klebe-Kontaktfenster 32 ausgebildet, das sich von herkömmlichen Kontaktfenstern dadurch unterscheidet, dass innerhalb des Kontaktfensters 32 einzelne Bereiche der Passivierungsschicht 26 und der darunter befindlichen Antireflexionsschicht 24 noch vorhanden sind. Diese in diesem Ausführungsbeispiel als einzelne Inseln 34 bzw. als von dem Kontaktfensterrand 36 vorstehende Vorsprünge 38 sind beispielsweise in der Draufsicht gemäß Fig. 2 zu erkennen. Nach der so erfolgten Strukturierung des Klebe-Kontaktfensters 32 liegen innerhalb eines Metallleiterbahn-Anschlussfeldes 40 also nur die in der Draufsicht gemäß Fig. 2 sichtbaren Bereiche 42 frei.

Anschließend wird zur Herstellung einer Klebeverbindung mit beispielsweise dem Rückseitenkontakt 44 des LED-Chips 14 elektrisch leitender Kleber (Leitkleber) 46 in das Klebe-Kontaktfenster 32 oder innerhalb eines Teils dieses appliziert. In diesen Leitkleber 46 wird dann der LED-Chip 14 eingesetzt. Bei dem elektrisch leitenden Kleber handelt es sich beispielsweise um einen mit elektrisch leitenden Partikeln gefüllten Epoxy-Kleber, beispielsweise einen mit über 80 % mit Silber gefüllten Epoxy-Kleber.

Wie in Fig. 1 dargestellt, erfolgt nun der Stromfluss zwischen dem Rückseitenkontakt 44 und dem Anschlussfeld 40 der Metallisierungsbahn 22 über den Leitkleber 46 und die unterhalb der Ätzkanten 48 der Passivierungsschicht 26 befindlichen Ätzkanten 50 der Antireflexionsschicht 24 wie über diese zum Anschlussfeld 40. Dieser in Fig. 1 mit 52 gekennzeichnete Stromfluss bleibt auch dann aufrechterhalten, wenn ein direkter elektrischer Kontakt an der Kontaktfläche des Leitklebers 46 mit dem Anschlussfeld 40 auf Grund der Bildung von Oxidation des Materials des Anschlussfeldes 40 nicht möglich ist.

Die Fign. 2 bis 6 zeigen verschiedene Varianten der Ausgestaltung eines Klebekontaktfensters 32 nach der Erfindung. Allen Ansätzen gemeinsam ist die Tatsache, dass die innerhalb des Klebe-Kontaktfensters 32 freiliegende Länge der Ätzkante 50 der erfindungsgemäß für die elektrische Verbindung benutzten Antireflexionsschicht aus z.B. TiN um ein Vielfaches gegenüber einer Rechteck- oder Quadratöffnung verlängert ist. Damit wird eine ausreichende elektrische Anbindung des Leitklebers 46 zur elektrisch leitenden Antireflexionsschicht 24 zur Verfügung gestellt.

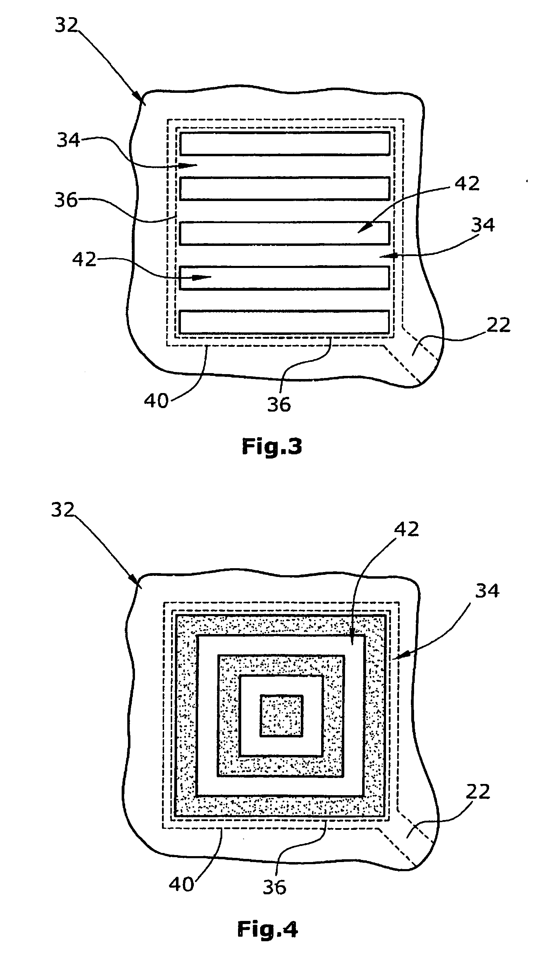

Dies wird gemäß Fig. 2 durch eine schachbrettartige Anordnung der freien Bereiche 42 und der mit der Passivierungs- und der Antireflexionsschicht 26,24 ausgefüllten Bereiche 34 realisiert. Gemäß Fig. 3 sind innerhalb des Klebe-Kontaktfensters 32 schlitzförmige freiliegende Bereiche 42 und das Kontaktfenster 32 überbrückende rippenförmige Bereiche 34 aus Passivierungs- und darunter befindlicher Antireflexionsschicht 26,24 realisiert, Fig. 4 zeigt eine Variante, bei der die Bereiche 34 als innerhalb des Kontaktfensters 32 verlaufende konzentrische Ringe ausgebildet sind, zwischen denen die ebenfalls ringförmigen freiliegenden Bereiche 42 angeordnet sind.

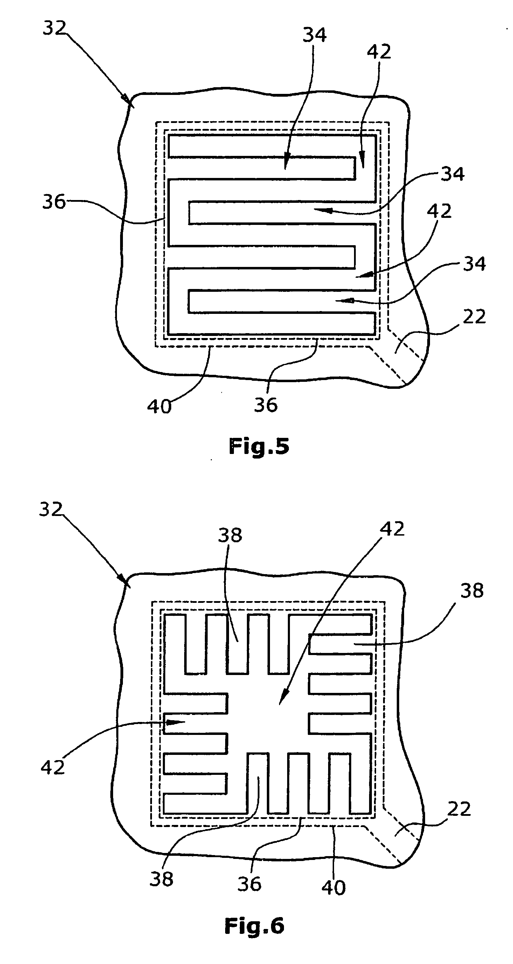

Fig. 5 zeigt zwei von gegenüberliegenden Abschnitten des Randes 36 des Kontaktfensters gegeneinander gerichtete Kammstrukturen aus Bereichen 34, zwischen denen sich ein mäanderförmiger freier Bereich 42 bildet. Fig. 6 schließlich zeigt eine Ausgestaltung der Struktur eines Klebe-Kontaktfensters 32, bei der sich vom Rand 36 aus einzelne vorspringende Bereiche 34 aus Passivierungsschicht 26 und darunter befindlicher Antireflexionsschicht 24 erstrecken. Der freiliegende Bereiche 42 bildet sich zwischen diesen einzelnen Vorsprüngen.

Nach der Erfindung wird also die TiN-Antireflexionsschicht 24 oder, allgemein ausgedrückt, eine elektrisch leitende nicht einer Selbstpassivierung unterliegenden Schutzschicht (z.B. Paladium) auf der eigentlichen Metallschicht 20 eines Halbleiterchips 12 als elektrisches Kontaktmaterial verwendet. Über die Ätzkante 50 dieser Antireflexionsschicht 24 ist eine Möglichkeit der elektrischen Verbindung mit dem Leitkleber 46 gegeben. Sollten also die an die Ätzkante der Antireflexionsschicht 24 angrenzenden freiliegenden Bereiche eines Anschlussfeldes 40 einer Metallisierungsbahn 22 beispielsweise wegen einer Oxidation keine oder eine nur unzureichende oder instabile elektrische Verbindung zum Leitkleber 46 bereitstellen, ist die elektrische Verbindung über die Ätzkanten der elektrisch leitenden Antireflexionsschicht 24 und über diese zum Anschlussfeld 40 gegeben.

Die Erfindung wurde vorstehend anhand von Ausführungsbeispielen beschrieben, bei denen die Ätzkante 50 der elektrisch leitenden Antireflexionsschicht 24 durch spezielle Ausgestaltung des Klebe-Kontaktfensters 32 verlängert ist. Dies ist für die Erfindung aber nicht zwingend erforderlich. Grundsätzlich kann das Klebe-Kontaktfenster rechteckig bzw. quadratisch ausgebildet sein, also vier gradlinige Randabschnitte aufweisen.

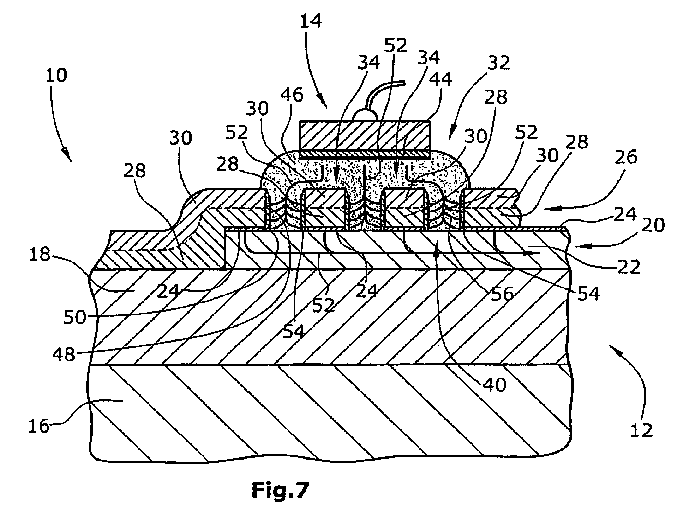

Anhand von Fig. 7 wird noch auf eine weitere Besonderheit der Kontaktierung des elektrisch leitenden Klebers 46 mit den Ätzkanten 50 der Antireflexionsschicht 24 eingegangen. Das Ausführungsbeispiel gemäß Fig. 7 entspricht nahezu identisch dem Ausführungsbeispiel gemäß Fig. 1, weshalb für gleiche Teile in beiden Figuren auch die gleichen Bezugszeichen verwendet sind. Der Unterschied besteht darin, dass die freiliegenden Ätzkanten 50,48 der Antireflexionsschicht 24 und der Passivierungsschicht 26 mit einer Kontaktierungsschicht 54 überdeckt sind. Diese Kontaktierungsschicht 54 besteht aus einem elektrisch leitenden Material und ist elektrisch mit der Ätzkante 50 der Antireflexionsschicht 24 verbunden (durch direkten Kontakt). Der Leitkleber 46 steht nun in Kontakt mit der Kontaktierungsschicht 54, was dazu führt, dass die Fläche, über die der Leitkleber 46 elektrisch an die Ätzkante 50 der Antireflexionsschicht 24 angebunden ist, stark vergrößert ist. Die Kontaktierungsschicht 54 steht in elektrisch leitendem Kontakt mit der Ätzkante 50 der Antireflexionsschicht 24. Sie erstreckt sich darüber hinaus über zumindest einen Teilbereich der Ätzkante 48 der Passivierungsschicht 26, d.h. zumindest teilweise über die Höhenerstreckung und/oder die Längserstreckung dieser Ätzkante 48. Neben der vergrößerten elektrischen Anbindungsfläche für den Leitkleber 46 hat die Kontaktierungsschicht 54 auch den Vorteil, dass es zu einer Kontaktierung zwischen dem Leitkleber 46 und der Kontaktierungsschicht 54 auch dann kommt, wenn in den Eckenbereichen der Kontaktierungsschicht 54 zum Anschlussfeld 40 hin mit der Ausbildung von einzelnen Freiräumen aufgrund von Oberflächenspannungen oder dergleichen des Leitklebers 46 zu rechnen sein könnte, Durch die Verlängerung des Kontaktbereichs zwischen der Ätzkante 50 der Antireflexionsschicht 24 und dem Leitkleber 46 kommt es also aufgrund der Kontaktierungsschicht 54 stets zu einer zuverlässigen und großflächigen Kontaktierung, so dass sich zusätzliche, bei 56 angedeutete Strompfade ergeben.

Die Kontaktierungsschicht 54 kann technologisch wie die bei MOS-Transistoren bekannten Spacer hergestellt werden. Dazu wird nach Freilegung der Kontaktfenster auf die Passivierungsschicht 26 und die freiliegenden Anschlussfelder 40 eine Schicht aus elektrisch leitendem Material, beispielsweise einer TiN-Schicht, aufgebracht. Anschließend wird diese Schicht anisotrop wieder weggeätzt, bis nur noch Material der Schicht an den Ätzkanten 48,50 verbleibt. Aufgrund des anisotropen Ätzvorgangs nimmt die Dicke der Kontaktierungsschicht 54 zum Anschlussfeld 40, also mit zunehmender Tiefe des Klebe-Kontaktfensters 32 hin, zu. Das Aufbringen der Schicht, die dann anschließend anisotrop geätzt wird, um die Kontaktierungsschicht 54 zu erzeugen, kann selektiv lediglich im Bereich eines Klebe-Kontaktfensters 32 aufgebracht werden, wobei das Material dieser Schicht zumindest beidseitig der Ätzkanten 48,50 aufgetragen werden muss, so dass es teilweise das Anschlussfeld 40 (in dessen den Ätzkanten 48,50 benachbarten Bereichen) und die Passivierungsschicht (in deren dem Klebe-Kontaktfenster 32 nahen Randbereich) überdeckt.

Bei der Beschreibung des Ausführungsbeispiels wurde davon ausgegangen, dass der zur Verwendung kommende Halbleitertechnologie-Prozess bereits *in situ* eine Schutzschicht im Sinne der Erfindung zur Verhinderung der Oxidation der darunter liegenden Metallschicht vorsieht. Im Ausführungsbeispiel übernimmt diese Funktion die Antireflexionsschicht. Bei HalbleitertechnologieProzessen, die ohne Antireflexionsschicht die Strukturierung der Metallschicht ermöglicht, wird erfindungsgemäß eine die Oberflächenoxidation der Metallschicht verhindernde Schutzschicht aufgetragen, was einen letztendlich einfachen zusätzlichen Prozessschritt bedeutet, da die Schutzschicht ganzflächig auf der Metallschicht aufgetragen wird, was verhältnismäßig einfach zu realisieren ist.

## Patentansprüche

1. Halbleiterbauelementanordnung mit
- einem ersten Halberleiterbauelement (12), das eine außenliegende Passivierungsschicht (26) mit einer darunter angeordneten Metallschicht (20), aufweist
- mindestens einem in der Passivierungsschicht (26) erzeugten Kontaktfenster (32) für die Metallschicht (20), wobei innerhalb des Kontaktfensters (32) die Metallschicht (20) frei liegt und das Kontaktfenster (32) längs seines Randes (36) durch Seitenkanten (48,50) der Passivierungsschicht (26) begrenzt ist, und
- einem zweiten Halbleiterbauelement (14), das ein dem mindestens einen Kontaktfenster (32) des ersten Halbleiterbauelements (12) zugewandtes elektrisches Anschlussfeld (44) aufweist,
- wobei zwischen dem im Kontaktfenster (32) des ersten Halbleiterbauelements (12) freiliegenden Bereich (42) der Metallschicht (20) und dem Anschlussfeld (44) des zweiten Halbleiterbauelements (14) ein elektrisch leitendes Klebematerial (46) angeordnet ist,
**dadurch gekennzeichnet,**
- **dass** sich auf der Metallschicht (20) eine einer Selbstpassivierung nicht unterliegende, elektrisch leitende Schutzschicht (24) befindet,
- **dass** das Kontaktfenster (32) für die Metallschicht (20) auch in der Schutzschicht (24) ausgebildet ist,
- **dass** das in dem Kontaktfenster (32) angeordnete Klebematerial (46) elektrisch mit zumindest Teilen der zum Kontaktfenster (32) des ersten Halbleiterbauelements (12) freillegenden Kanten (50) der Schutzschicht (24) verbunden ist und
- **dass** das Kontaktfenster (32) des ersten Halbleiterbauelements (12) zur Verlängerung seines Randes (36) eine Vielzahl von Einzelkontaktfensterbereichen (42), aufweist.

2. Halbleiterbauelementanordnung nach Anspruch 1, **dadurch gekennzeichnet, dass** die Einzelkontaktfensterbereiche (42) zwischen Ausbuchtungen des Randes (36) des Kontaktfensters (32) des ersten Halbleiterbauelements (12) gebildet sind.

3. Halbleiterbauelementanordnung nach Anspruch 1 oder 2, **dadurch gekennzeichnet, dass** innerhalb des Kontaktfensters (32) des ersten Halbleiterbauelements (12) mehrere erhabene Bereiche (34) aus dem Material der Passivierungsschicht (26) und dem darunter angeordneten Material der Schutzschicht (24) ausgebildet sind.

4. Halbleiterbauelementanordnung nach einem der Ansprüche 1 bis 3, **dadurch gekennzeichnet, dass** die Schutzschicht (24) eine Antireflexionsschicht zur Reduktion möglicher Reflexionen bei einer durch einen fotolithographischen Prozess erzeugten Strukturierung der Metallschicht (20) ist.

5. Halbleiterbauelementanordnung nach Anspruch 4, **dadurch gekennzeichnet, dass** die Antireflexionsschicht (24) TiN aufweist.

6. Halbleiterbauelementanordnung nach einem der Ansprüche 1 bis 5, **dadurch gekennzeichnet, dass** zumindest innerhalb von Teilbereichen des Randes (36) des Kontaktfensters (32) an zumindest Teilbereichen der Seitenkanten (48,50) der Passivierungsschicht (26) und der Schutzschicht (24) eine Kontaktierungsschicht (54) aus einem elektrisch leitenden Material angeordnet ist, die elektrisch leitend mit der Seitenkante (50) der Schutzschicht (24) verbunden ist und mit der das Klebematerial (46) in elektrisch leitendem Kontakt steht.

## Claims

1. A semiconductor component assembly comprising:
- a first semiconductor component (12) comprising an exterior passivation layer (26) with a metal layer (20) arranged thereunder,
- at least one contact window (32) for the metal layer (20), formed in the passivation layer (26), the metal layer (20) being exposed within the contact window (32) and the contact window (32) being defined along its edge (36) by lateral edges (48, 50) of the passivation layer (26), and
- a second semiconductor component (14) comprising an electric connector pad (44) facing said at least one contact window (32) of the first semiconductor component (12),
- an electrically conductive adhesive material (46) being arranged between the portion (42) of the metal layer (20) exposed in the contact window (32) of the first semiconductor component (12) and the connector pad (44) of the second semiconductor component (14),
**characterized in that**
- an electrically conductive protective layer (24) is provided on the metal layer (20), said protective layer not being subject to self-passivation,
- said contact window (32) for the metal layer (20) is also formed in the protective layer (24),
- said adhesive material (46) provided in the contact window (32) is electrically connected to at least parts of the edges (50) of the protective layer (24) that are exposed towards the contact window (32) of the first semiconductor element (12), and
- the contact window (32) of the first semiconductor element (12) comprises a plurality of individual contact window portions (42) for extending the edge (36) of said element.

2. The semiconductor component assembly of claim 1, **characterized in that** said individual contact window portions (42) are formed between bulges of the edge (36) of said contact window (32) of the first semiconductor component (12).

3. The semiconductor component assembly of claim 1 or 2, **characterized in that** a plurality of raised portions (34) are formed within the contact window (32) of said first semiconductor component (12), said raised portions being formed from the material of the passivation layer (26) and the underlying material of the protective layer (24).

4. The semiconductor component assembly of one of claims 1 to 3, **characterized in that** the protective layer (24) is an anti-reflection layer for reducing possible reflections when said metal layer (20) is formed with a pattern by a photolithographic process.

5. The semiconductor component assembly of claim 4, **characterized in that** said anti-reflection layer (24) comprises TiN.

6. The semiconductor component assembly of one of claims 1 to 5, **characterized in that** a contacting layer (54) of electrically conductive material is arranged at least within partial regions of the edge (36) of the contact window (32) at at least parts of the lateral edges (48, 50) of the passivation layer (26) and the protective layer (24), said contacting layer being connected in an electrically conductive manner to the lateral edge (50) of the protective layer (24) and being in electrically conductive contact with the adhesive material (46).

## Revendications

1. Agencement de composant semiconducteur comprenant
- un premier composant semiconducteur (12) comprenant une couche de passivation (26) extérieure avec une couche en métal (20) sous-jacente,
- au moins une fenêtre de contact (32) formée pour la couche en métal (20) dans la couche de passivation (26), ladite couche en métal (20) étant exposée dans ladite fenêtre de contact (32) et la fenêtre de contact (32) étant limitée le long de son bord (36) par des bords latéraux (48, 50) de ladite couche de passivation (26), et
- un deuxième composant semiconducteur (14) comprenant une plage de connexion électrique (44) tournée vers ladite au moins une fenêtre de contact (32) dudit premier composant semiconducteur (12),
- un matériau adhésif (46) électriquement conducteur étant prévu entre la partie (42) de ladite couche en métal (20) exposée dans ladite fenêtre de contact (32) dudit premier composant semiconducteur (12) et la plage de connexion (44) dudit deuxième élément semiconducteur (14),
**caractérisé en ce que**
- une couche de protection (24) électriquement conductrice et non pas soumise à une auto-passivation est située sur ladite couche en métal (20),
- ladite fenêtre de contact (32) pour la couche en métal (20) est aussi formée dans la couche de protection (24),
- le matériau adhésif (46) prévu dans ladite fenêtre de contact (32) est connecté électriquement à au moins des parties des bords (50) de la couche de passivation (24) exposés vers ladite fenêtre de contact (32) dudit premier élément semiconducteur (12), et
- ladite fenêtre de contact (32) dudit premier élément semiconducteur (12) comprend plusieurs régions de fenêtre de contact (42) individuelles pour élonger son bord (36).

2. Composant semiconducteur selon la revendication 1, **caractérisé en ce que** lesdites régions de fenêtre de contact (42) individuelles sont formées entre des saillies du bord (36) de ladite fenêtre de contact (32) dudit premier; composant semiconducteur (12).

3. Composant semiconducteur selon les revendications 1 ou 2, **caractérisé en ce que** plusieurs parties saillantes (34), formées du matériau de la couche de passivation (26) et du matériau sous-jacent de la couche de protection (24), sont formées dans la fenêtre de contact (32) dudit premier élément semiconducteur (12).

4. Composant semiconducteur selon l'une quelconque des revendications 1 à 3, **caractérisé en ce que** ladite couche de protection (24) est une couche anti-réflexion pour réduire des réflexions possibles en cas d'une structuration de la couche en métal (20) générée par un procès photolithographique.

5. Composant semiconducteur selon la revendication 4, **caractérisé en ce que** la couche anti-réflexion (24) comprend du TiN.

6. Composant semiconducteur selon l'une quelconque des revendications 1 à 5, **caractérisé en ce qu'**au moins dans des régions partielles du bord (36) de ladite fenêtre de contact (32), une couche de contact (54) en un matériau électriquement conducteur est formée au moins dan des régions partielles des bords latéraux (48, 50) de ladite couche de passivation (26) et de ladite couche de protection (24), ladite couche étant connectée de manière électriquement conductrice au bord latéral (50) de ladite couche de protection (24) et étant en contact électriquement conducteur avec ledit matériau adhésif (46).
